(19) Europäisches Patentamt European Patent Office Office européen des brevets

(11) **EP 2 247 891 B1**

(12) **EUROPEAN PATENT SPECIFICATION**

(45) Date of publication and mention
of the grant of the patent:
**05.06.2019 Bulletin 2019/23**

(21) Application number: **09712416.8**

(22) Date of filing: **18.02.2009**

(51) Int Cl.:
*F21K 9/00* (2016.01)    *F21V 3/04* (2018.01)
*F21V 3/12* (2018.01)    *H05B 33/08* (2006.01)
*F21Y 115/10* (2016.01)    *F21Y 113/17* (2016.01)

(86) International application number:
**PCT/IB2009/050650**

(87) International publication number:
**WO 2009/104136 (27.08.2009 Gazette 2009/35)**

(54) **GLS-ALIKE LED LIGHT SOURCE**

GLÜHLAMPENÄHNLICHE LED-LICHTQUELLE

SOURCE DE LUMIÈRE À DIODES ÉLECTROLUMINESCENTES EN FORME DE SYSTÈME D'ÉCLAIRAGE GÉNÉRAL

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **21.02.2008 EP 08101827**

(43) Date of publication of application:
**10.11.2010 Bulletin 2010/45**

(73) Proprietor: **Signify Holding B.V.
5656 AE Eindhoven (NL)**

(72) Inventors:
• **JUESTEL, Thomas
5656 AE Eindhoven (NL)**
• **MERIKHI, Jacqueline
5656 AE Eindhoven (NL)**
• **OHLAND, Henning
5656 AE Eindhoven (NL)**
• **OPITZ, Joachim
5656 AE Eindhoven (NL)**
• **RADERMACHER, Harald J. G.
5656 AE Eindhoven (NL)**
• **WIECHERT, Detlef U.
5656 AE Eindhoven (NL)**

(74) Representative: **Verweij, Petronella Daniëlle et al
Signify Netherlands B.V.
Intellectual Property
High Tech Campus 7
5656 AE Eindhoven (NL)**

(56) References cited:
WO-A-00/57490          WO-A-2007/114614
DE-A1-102004 004 947   DE-A1-102005 020 695
DE-U1- 20 121 470      JP-A- 2003 051 209
US-A1- 2005 127 381    US-A1- 2007 258 240

**Description**

FIELD OF THE INVENTION

The invention relates to a white light source comprising at least two light emitting diodes (LEDs).

BACKGROUND OF THE INVENTION

The WO 0063977 A1 discloses a light source comprising blue LEDs in a transparent incandescent lamp bulb. The light source further comprises a converter material arranged in a spiral like the filament of a conventional incandescent lamp and a reflective coating disposed on the inside of the transparent bulb.

The JP 2003 051209 A discloses a light source with a plurality of LEDs of different colors disposed inside a transparent plastic globe, wherein the inner walls of said globe are coated with a fluorescent film.

The DE 10 2005 020695 A1 discloses a light source comprising at least two LEDs of different colors that are embedded in two luminescent materials of different absorption and emission characteristics.

The WO 00/57490 A discloses a lamp with a plurality of LEDs disposed within a reflector.

The US 2007/258240 A1 discloses a light source comprising two different LEDs that can individually be controlled. By programming the control system accordingly, a dimming procedure can be realized with characteristics similar to those of an incandescent lamps.

SUMMARY OF THE INVENTION

Based on this background it was an object of the present invention to provide an alternative light source having the appearance of a GLS (General Lighting Services) lamp, wherein it is desirable that this light source is well suited for indoor applications while having a lower power consumption than conventional incandescent lamps and providing a tunable color temperature.

This object is achieved by a white LED light source according to claim 1. Preferred embodiments are disclosed in the dependent claims.

The white LED light source according to the present invention may optionally comprise the following components:

a) A transparent bulb through which the light source can emit its light. At least a part of the bulb may optionally have a reflective coating.

b) A luminescent layer disposed on the surface (typically the inside) of the bulb, covering the whole surface or at least a part of it and being capable of converting light from the first and/or the second LED into a different (usually longer) wavelength.

The bulb of the light source has preferably a GLS look-alike shape, for example a shape like a sphere/ellipsoid or a pear. The bulb may also have a conical shape known under the terms reflector lamp or PAR lamp, particularly if it is (partly) covered with a reflective coating. The bulb is preferably equipped with a standard socket for conventional incandescent lamps.

The described light source has the advantage to use power-efficient, robust and inexpensive LEDs as primary light sources while allowing to be designed with an appearance and behavior like a conventional incandescent lamp. The use of two different LEDs and of an additional luminescent layer allows to archieve an overall emission spectrum with excellent properties. As the luminescent layer is disposed on the surface of the bulb, no additional carrier for the luminescent material is necessary, and the emission can be made spatially very homogeneous.

The invention comprises a white LED light source with the following components:

a) At least one near ultraviolet (UV) emitting first LED and one second LED of different type that both can selectively (i.e. independently of each other) be controlled.

b) A red emitting luminescent layer disposed on a surface that is irradiated by the two LEDs.

Optionally, the luminescent layer may be disposed on a transparent bulb.

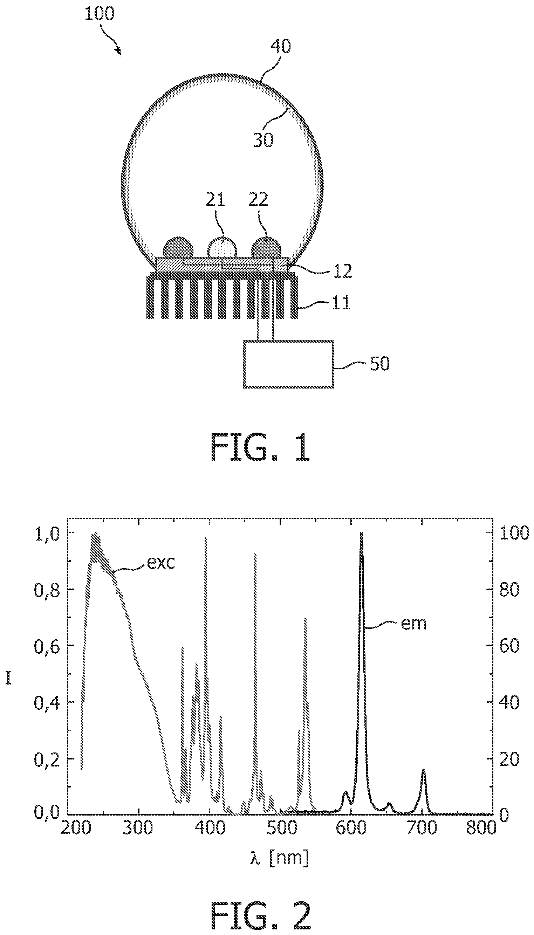

The total light output of the LED light source depends in a favorable way on the individual activities of the first and second LED, as it is a mixture of both the direct LED lights and the red light of the excited luminescent layer. By selectively controlling the two LEDs, the overall light output can therefore be tuned as desired. The red emitting luminescent layer may for example comprise a luminescent material according to claim 6 (e.g. $LiEuMo_2O_8$), which has a stable emission spectrum regardless of the excitation wavelength and is excitable by UV (e.g. 395 nm) and by light of the second LED if this is assumed to cover the range of about 465 nm (used e.g. in some white LEDs) or other spectral ranges where the phosphor material can be excited, e.g. about 540 nm (cf. Figure 2). As a result, the $LiEuMo_2O_8$ layer disposed in a remote location (e.g. inside a bulb) is excited by the emission of both LEDs. Varying the intensity balance between the LEDs then changes the mixed light output (comprising a wanted leakage light of white LEDs and UV). A green to yellow emitting luminescent material is added that is less excitable by UV.

In the following, various optional embodiments of the invention are described that relate to LED light sources according to the invention.

Thus the LEDs of the light source are preferably mounted on a heat sink for efficiently removing dissipated power during the operation of the lamp.

According to the invention, the first LED is a near ultraviolet (UV) emitting LED with an emission peak in a range from about 370 nm to about 400 nm.

In the invention, the second LED is a blue emitting LED, particularly an LED with an emission peak in the range from about 400 nm to about 480 nm. Upon dimming, the blue LED reduces both the color temperature (warm-white appearance) and the overall brightness, as desirable in the application.

The luminescent layer comprises two different luminescent materials, each of which fits optimal to one of the two LEDs.

The luminescent layer comprises a red emitting luminescent material, for instance a material comprising a composition in accordance to the general formulas $(Sr_{1-x-y}Ca_xBa_y)_{2-z}Si_5N_8:Eu_z$ ($0 \leq x \leq 1$, $0 \leq y \leq 1$, $0.1 \leq z \leq 2$), $(Sr_{1-x}Ca_x)S:Eu$ ($0 \leq x \leq 1$), $(Sr_{1-x-y}Ca_xBa_y)_{3-z}Si_2N_2O_4:Eu_z$ ($0 \leq x \leq 1$, $0 \leq y \leq 1$, $0.1 \leq z \leq 3$), $CaAlSiN_3:Eu$, $MLn_{1-z}(Mo_{1-x}W_x)_2O_8:Eu_z$ (with M = Li, Na, K, Rb, Cs and Ln = Y, La, Ga and $0 \leq x \leq 1$, $0.1 \leq z \leq 1$), $Ln_{2-z}(Mo_{1-x}W_x)_2O_9:Eu_z$ (with Ln = La, Gd, Lu and $0 \leq x \leq 1$, $0.2 \leq z \leq 2$), or $Ln_{2-z}(Mo_{1-x}W_x)_3O_{12}:Eu_z$ (with Ln = La, Gd, Lu and $0 \leq x \leq 1$, $0.2 \leq z \leq 2$).

According to the invention, the luminescent layer comprises a green to yellow emitting luminescent material, particularly a material comprising a composition in accordance to the general formulas $(Sr_{1-x-y}Ca_xBa_y)_2SiO_4:Eu$ ($0 \leq x \leq 1$, $0 \leq y \leq 1$), $(Sr_{1-x}Ca_x)Si_2N_2O_2:Eu$ ($0 \leq x \leq 1$), $SrLi_2SiO_4:Eu$, $(Y_{1-x-y-z}Lu_xGd_yTb_z)_3(Al_{1-a}Ga_a)_5O_{12}:Ce$ ($0 \leq a \leq 1$, $0 \leq x \leq 1$, $0 \leq y \leq 1$, $0 \leq z \leq 1$), $Y_3Al_{5-x}Si_xO_{12-x}N_x:Ce$, or $CaAlSiN_3:Ce$.

The LED light source is further preferably designed in such a way that it shows a red-shift in its overall emission spectrum upon dimming (i.e. upon decreasing the electrical power supply to both LEDs or at least to the second LED). This makes the light source particularly apt for indoor lighting purposes where a dimming behavior like that of an incandescent lamp is desired.

The LED light source is preferably coupled to a control and power supply unit for individually controlling the power delivered to the first LED and the second LED, respectively. Thus an independent control of brightness and color of the light source becomes possible.

The aforementioned control and power supply unit is preferably adapted to

    a) reduce the power delivered to one of the at least two LEDs, and
    b) keep the power delivered to the other of the at least two LEDs substantially constant

when the light source is set to a dimming state.

These and other aspects of the invention will be apparent from and elucidated with reference to the embodiment(s) described hereinafter. These embodiments will be described by way of example with the help of the accompanying drawings in which:

BRIEF DESCRIPTION OF THE DRAWINGS

| | |
|---|---|
| Figure 1 | shows schematically a sectional view through an LED light source according to the present invention; |
| Figure 2 | shows the absorption and emission spectrum of a luminescent material that can be used as coating on the inside of the bulb of the LED light source; |
| Figures 3 and 4 | show emission spectra of LEDs that can be used in the LED light source; |
| Figures 5 and 6 | show overall emission spectra of light sources for different degrees of dimming. |

Like reference numbers in the Figures refer to identical or similar components.

DETAILED DESCRIPTION OF EMBODIMENTS

Inorganic LEDs enable light sources with new features, such as arbitrary color tuning or arbitrary dimming without flickering. Since inorganic LEDs typically emit a single color, it is possible to combine red, green and blue LEDs and blend the emitted light by means of a secondary optic to obtain a dynamically controllable light source. This concept yields thus very efficient and color-tunable light sources, but a high color rendering index (CRI) can only be obtained by application of four or five different LED types, e.g. by the combination of red, orange, yellow, green, and blue LEDs, due to the rather narrow emission bands of AlInGaP and AlInGaN LEDs. This is a serious drawback, since the complexity of the required driving electronics increases with the number of LED types. To avoid these problems, it is possible to base a white LED light source on a single LED type, e.g. blue emitting InGaN dies, and a color converter, comprising one or two luminescent compositions, e.g. YAG:Ce and CaS:Eu.

In order to reduce energy consumption by lighting, the replacement of the GLS (General Lighting Services) lamp by other light sources, in particular by energy saving lamps (CFLi) or LEDs, is highly desirable. However, the light of the CFLi lamps is often perceived much different from GLS lamps (uncomfortable) because of their different color point and the quite different emission spectra.

The present invention therefore proposes an LED light source with two LED types and a luminescent layer which comprises two luminescent compositions. The light source preferably has a GLS-look-alike shape, and its components (LEDs, phosphors) are selected in such a way, that the resulting LED lamp shows a red-shift of the white color point upon dimming.

An exemplary embodiment of such an LED light source 100 is schematically shown in Figure 1 and comprises:

- Two different types of LEDs 21, 22 as primary light sources; typically there is a number of three to twelve LEDs, mounted on an LED mount 12 in combination with a heat sink 11.
- A glass or plastic (transparent polymer) bulb 40 with a shape similar to an incandescent lamp.
- A luminescent layer 30 coated onto the inside of the bulb 40 to achieve a white lamp spectrum.

The two LEDs 21, 22 are connected to a control and power supply unit 50 (which may be considered as a part of the light source 100 or as an external component) by which they are individually supplied with power. Moreover, it should be noted that the bulb is not a necessary component of the lamp as the luminescent layer might also be disposed on another surface.

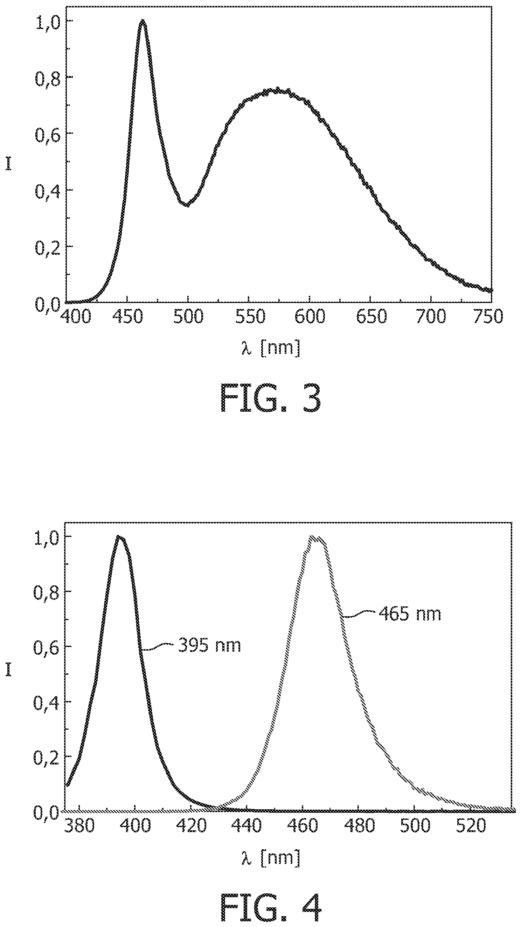

The first LED 21 is of a near UV LED type, with an emission peak between 370 and 400 nm. A typical spectrum for this LED with an emission peak at 395 nm is shown by the left curve in the diagram of Figure 4 (vertical axis: normalized emission intensity I; horizontal axis: wavelength $\lambda$).

The second LED 22 may be a blue LED with peak emission between 460 and 470 nm. A typical spectrum for this LED with a peak at 465 nm is shown by the right curve in Figure 4.

The luminescent layer 30 comprises two luminescent compositions. The response of the first luminescent composition is optimized to the first LED type and the response of the second luminescent composition is optimized to the second LED type.

Figure 2 shows the emission spectrum (em) and excitation spectrum (exc) of a typical red line emitting phosphor ($LiEuMo_2O_8$) excitable in a wide range, e.g. by near UV LEDs (370-400 nm) and by 465 nm or 540 nm, which can be used as a component of the luminescent layer 30.

The following construction of the LED light source 100 is particularly preferred:

## a) UV + blue LED:

The first embodiment of an LED light source comprises near UV LEDs 21 (370-400 nm) and blue LEDs 22 (460-470 nm) and a luminescent layer 30 with two luminescent compositions.

The first luminescent composition is a green to yellow-orange emitting phosphor (emitting for example more than about 50 % of its energy in the range of 520-580 nm)

efficiently luminescent upon 460-470 nm excitation according to one of the following formulas:

- $(Sr_{1-x-y}Ca_xBa_y)_2SiO_4$:Eu
- $(Sr_{1-x}Ca_x)Si_2N_2O_2$:Eu
- $SrLi_2SiO_4$:Eu
- $(Y_{1-x-y-z}Lu_xGd_yTb_z)_3(Al_{1-a}Ga_a)_5O_{12}$:Ce
- $Y_3Al_{5-x}Si_xO_{12-x}N_x$:Ce
- $CaAlSiN_3$:Ce

The second luminescent composition is a red emitting phosphor (600-680 nm) efficiently luminescent upon 370-400 nm excitation according one of the following formulas:

- $(Sr_{1-x-y}Ca_xBa_y)_2Si_5N_8$:Eu
- $(Sr_{1-x}Ca_x)S$:Eu
- $(Sr_{1-x-y}Ca_xBa_y)_3Si_2N_2O_4$:Eu
- $CaAlSiN_3$:Eu
- $MEu(Mo_{1-x}W_x)_2O_8$ (with M = Li, Na, K, Rb, Cs)
- $Ln_2(Mo_{1-x}W_x)_2O_9$:Eu (with Ln = La, Gd, Lu)
- $Ln_2(Mo_{1-x}W_x)_3O_{12}$:Eu (with Ln = La, Gd, Lu)

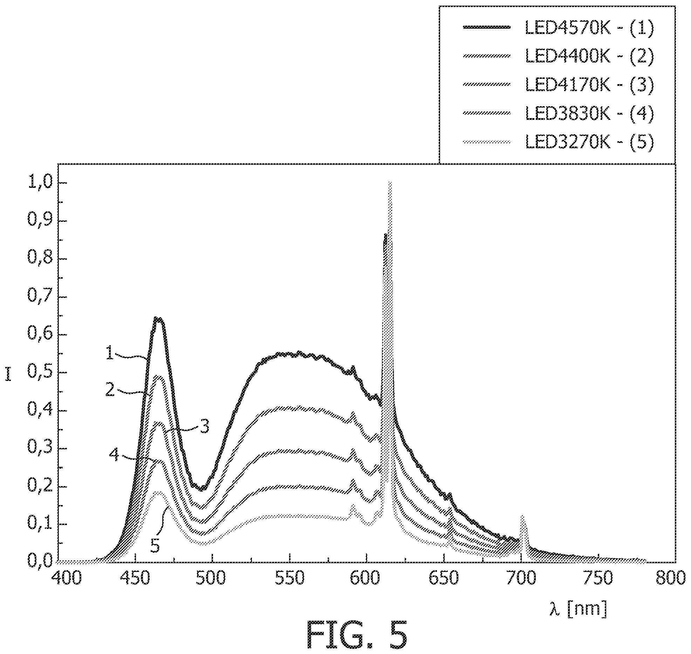

Figure 5 shows emission spectra of such a white LED light source with 465 nm emitting (In,Ga)N LEDs, 395 nm emitting (In,Ga)N LEDs, and a luminescent layer comprising $Y_3Al_5O_{12}$:Ce and $LiEuMo_2O_8$ as function of the driving conditions. For this Figure, it is assumed that all the UV light is absorbed by the luminescent layer or the bulb.

Dimming the blue LEDs reduces both the color temperature and the overall brightness, as desirable in the application. This is achieved by the following fact: The excitation energy in the UV-range is kept at a stable level because only the blue LEDs are dimmed while the UV LEDs are driven at a constant power. The wavelengths of the LEDs and the excitation spectra of the red emitting material are arranged in a way that the emission due to the UV excitation is dominant with respect to the emission due to the blue excitation. Hence, there is a significant reduction of the blue and yellow to green emission (garnet phosphors) while the red emission (e.g. $LiEuMo_2O_8$) is substantially stable. The color rendering index is for all color temperatures between 80 and 85.

An example of a construction of an LED light source not being part of the invention is described below:

## b) UV + white LED:

The second embodiment of an LED light source comprises near UV LEDs 21 (370-400 nm) and white LEDs 22 (460-470 nm chip + a yellow garnet type phosphor) and a luminescent layer comprising only one luminescent composition. This luminescent composition is a red band or line emitting phosphor as mentioned above.

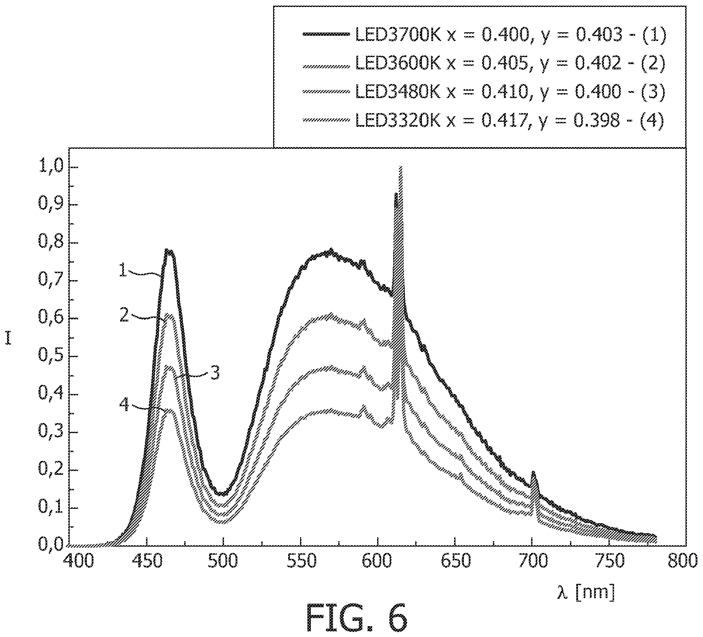

Figure 6 shows emission spectra of such a white LED light source with white emitting phosphor converted (In,Ga)N LEDs comprising an $(Y,Gd)_3Al_5O_{12}$:Ce phosphor, 395 nm emitting (In,Ga)N LEDs, and a luminescent

layer comprising $LiEuMo_2O_8$ as function of the driving conditions. Dimming the white pcLEDs reduces the color temperature, since the flux of the 395 nm UV LEDs, which mainly excites the $LiEuMo_2O_8$ phosphor, remains the same. The color rendering index is for all color temperatures between 80 and 85.

An advantage of the described LED light sources is that they emit white light similar to that known from incandescent and halogen lamps and that reducing the driving current (dimming) shifts the color temperature of the lamps from cold-white to warm-white. This is especially advantageous for indoor lighting applications. Moreover, the luminous efficiency of such an LED light source is not significantly reduced due to dimming, thus in contrast to what is known from incandescent, halogen and fluorescent lamps (the efficiency of the LED might even increase towards lower drive currents whereas the electronics might become less efficient at very low dimming levels).

The described light sources are in particular applicable in those surroundings, where

- deep red, skin, brown, and/or beige colors have to be evenly rendered,
- a comfortable, e.g. candle light, atmosphere is of large importance, and/or
- an incandescent-lamp-like dimming behavior is required.

Finally it is pointed out that in the present application the term "comprising" does not exclude other elements or steps, that "a" or "an" does not exclude a plurality, and that a single processor or other unit may fulfill the functions of several means. The invention resides in each and every novel characteristic feature and each and every combination of characteristic features. Moreover, reference signs in the claims shall not be construed as limiting their scope.

**Claims**

1. A white light-emitting diode (LED) light source (100) comprising:

   - a first LED (21), being a near ultraviolet (UV) LED with an emission peak in the range of about 370 nm to 400 nm, and
   - a second LED (22), being a blue LED with an emission peak in the range of about 400 nm to 480 nm,

   wherein the first LED (21) and the second LED (22) can both be selectively controlled,
   wherein the white LED light source (100) further comprises a luminescent layer (30) disposed on a surface that is irradiated by the first LED (21) and the second LED (22), and **characterised in that** the luminescent layer (30) comprises:

   - a first luminescent composition, being a green to yellow-orange emitting phosphor that is efficiently luminescent upon excitation with radiation in a range between 460 nm and 470 nm, the green to yellow-orange emitting phosphor being arranged to emit radiation in a range between 520 nm and 580 nm, and
   - a second luminescent composition, being a red emitting phosphor that is efficiently luminescent upon excitation with radiation in a range between 370 nm and 400 nm, the red emitting phosphor being arranged to emit radiation having a peak in a range between 600 nm and 680 nm.

2. The white LED light source (100) according to claim 1, further comprising a transparent bulb (40), wherein the first LED (21) and the second LED (22) are mounted in the bulb (40), and wherein the luminescent layer (30) is disposed on the surface of the bulb (40).

3. The white LED light source (100) according to claim 2, wherein the bulb (40) is at least partly covered with a reflective coating.

4. The white LED light source (100) according to claim 2, wherein the bulb (40) has the GLS-alike shape or a conical shape of reflector lamps.

5. The white LED light source (100) according to claim 1, wherein the LEDs (21, 22) are mounted on a heat sink (11).

6. The white LED light source (100) according to claim 1, wherein the second luminescent composition comprises a material having a composition in accordance to the general formulas $(Sr_{1-x-y}Ca_xBa_y)_{2-z}Si_5N_8:Eu_z$ ($0 \leq x \leq 1$, $0 \leq y \leq 1$, $0.1 \leq z \leq 2$), $(Sr_{1-x}Ca_x)S:Eu$ ($0 \leq x \leq 1$), $(Sr_{1-x-y}Ca_xBa_y)_{3-z}Si_2N_2O_4:Eu_z$ ($0 \leq x \leq 1$, $0 \leq y \leq 1$, $0.1 \leq z \leq 3$), $CaAlSiN_3:Eu$, $MLn_{1-z}(Mo_{1-x}W_x)_2O_8:Eu_z$ (with M = Li, Na, K, Rb, Cs and Ln = Y, La, Ga and $0 \leq x \leq 1$, $0.1 \leq z \leq 1$), $Ln_{2-z}(Mo_{1-x}W_x)_2O_9:Eu_z$ (with Ln = La, Gd, Lu and $0 \leq x \leq 1$, $0.2 \leq z \leq 2$), or $Ln_{2-z}(Mo_{1-x}W_x)_3O_{12}:Eu_z$ (with Ln = La, Gd, Lu and $0 \leq x \leq 1$, $0.2 \leq z \leq 2$).

7. The white LED light source (100) according to claim 1, wherein the first luminescent composition comprises a material having a composition in accordance to the general formulas $(Sr_{1-x-y}Ca_xBa_y)_2SiO_4:Eu$ ($0 \leq x \leq 1$, $0 \leq y \leq 1$), $(Sr_{1-x}Ca_x)Si_2N_2O_2:Eu$ ($0 \leq x \leq 1$), $SrLi_2SiO_4:Eu$, $(Y_{1-x-y-z}Lu_xGdyTb_z)_3(Al_{1-a}Ga_a)_5O_{12}:Ce$ ($0 \leq a \leq 1$, $0 \leq x \leq 1$, $0 \leq y \leq 1$, $0 \leq z \leq 1$), $Y_3Al_{5-x}Si_xO_{12-x}Nx:Ce$, or CaAlSiN3:Ce.

**8.** The white LED light source (100) according to claim 1, further comprising a control and power supply unit (50) for individually controlling the power delivered to the first LED (21) and the second LED (22), respectively.

**9.** The white LED light source (100) according to claim 8, wherein the control and power supply unit (50) is arranged for reducing the power delivered to the second LED (22), and for keeping the power delivered to the first LED (21) substantially constant when the white LED light source (100) is set to a dimming state.

## Patentansprüche

**1.** Weiße Leuchtdioden-(LED)-Lichtquelle (100), umfassend:

eine erste LED (21), die eine nahezu ultraviolette (UV) LED mit einem Emissionspeak im Bereich von etwa 370 nm bis 400 nm ist, und
eine zweite LED (22), die eine blaue LED mit einem Emissionspeak im Bereich von etwa 400 nm bis 480 nm ist,
wobei die erste LED (21) und die zweite LED (22) beide selektiv gesteuert werden können,
wobei die weiße LED-Lichtquelle (100) weiter eine Lumineszenzschicht (30) umfasst, die auf einer Oberfläche angeordnet ist, die von der ersten LED (21) und der zweiten LED (22) bestrahlt wird, und
**dadurch gekennzeichnet, dass** die Lumineszenzschicht (30) umfasst:

eine erste Lumineszenzzusammensetzung, die ein grün bis gelb-orange emittierender Leuchtstoff ist, der bei Anregung mit Strahlung in einem Bereich zwischen 460 nm und 470 nm effizient lumlnesziert, wobei der grün bis gelb-orange emittierende Leuchtstoff angeordnet ist, um Strahlung in einem Bereich zwischen 520 nm und 580 nm zu emittieren und
eine zweite Lumineszenzzusammensetzung, die ein rot emittierender Leuchtstoff ist, der bei Anregung mit Strahlung in einem Bereich zwischen 370 nm und 400 nm effizient lumlnesziert, wobei der rot emittierende Leuchtstoff angeordnet ist, um Strahlung mit einem Peak in einem Bereich zwischen 600 nm und 680 nm zu emittieren.

**2.** Weiße LED-Lichtquelle (100) nach Anspruch 1, weiter umfassend eine transparente Birne (40), wobei die erste LED (21) und die zweite LED (22) in der Birne (40) angebracht sind, und wobei die Lumineszenzschicht (30) auf der Oberfläche der Birne (40) angeordnet ist.

**3.** Weiße LED-Lichtquelle (100) nach Anspruch 2, wobei die Birne (40) mindestens teilweise mit einer reflektierenden Beschichtung bedeckt ist.

**4.** Weiße LED-Lichtquelle (100) nach Anspruch 2, wobei die Birne (40) die Glühlampenform oder eine konische Form von Reflektorlampen aufweist.

**5.** Weiße LED-Lichtquelle (100) nach Anspruch 1, wobei die LEDs (21, 22) an einem Kühlkörper (11) angebracht sind.

**6.** Weiße LED-Lichtquelle (100) nach Anspruch 1, wobei die zweite Lumineszenzzusammensetzung ein Material umfasst, das eine Zusammensetzung gemäß der allgemeinen Formeln $(Sr_{1-x-y}Ca_x Ba_y)_{2-z}Si_5N_8{:}Eu_z$ ($0 \le x \le 1$, $0 \le y \le 1$, $0{,}1 \le z \le 2$), $(Sr_{1-x}Ca_x)S{:}Eu_z$ ($0 \le x \le 1$), $(Sr_{1-x-y}Ca_x Ba_y)_{3-z}Si_2N_2O_4{:}Eu_z$ ($0 \le x \le 1$, $0 \le y \le 1$, $0{,}1 \le z \le 3$), $CaAlSiN_3{:}Eu$, $MLn_{1-z}(Mo_{1-x}Wx)_2O_8{:}Eu_z$ (wobei M = Li, Na, K, Rb, Cs und Ln = Y, La, Ga und $0 \le x \le 1$, $0{,}1 \le z \le 1$ ist), $Ln_{2-z}(Mo_{1-x}W_x)_2O_9{:}Euz$ (wobei Ln = La, Gd, Lu und $0 \le x \le 1$, $0{,}2 \le z \le 2$ ist) oder $Ln_{2-z}(Mo_{1-x}W_x)_3O_{12}{:}Eu_z$ (wobei Ln = La, Gd, Lu und $0 \le x \le 1$, $0{,}2 \le z \le 2$ ist) umfasst.

**7.** Weiße LED-Lichtquelle (100) nach Anspruch 1, wobei die erste Lumineszenzzusammensetzung ein Material umfasst, das eine Zusammensetzung gemäß den allgemeinen Formeln $(Sr_{1-x-y}Ca_x Ba_y)_2SiO_4{:}Eu$ ($0 \le x \le 1$, $0 \le y \le 1$), $(Sr_{1-x}Ca_x)Si_2N_2O_2{:}Eu$ ($0 \le x \le 1$), $SrLi_2SiO_4{:}Eu$, $(Y_{1-x-y-z}Lu_xGd_yTb_z)_3(Al_{1-a}Ga_a)_5O_{12}{:}Ce$ ($0 \le a \le 1$, $0 \le x \le 1$, $0 \le y \le 1$, $0 \le z \le 1$), $Y_3Al_{5-x}SixO_{12-x}Nx{:}Ce$ oder CaAlSiN3:Ce umfasst.

**8.** Weiße LED-Lichtquelle (100) nach Anspruch 1, weiter umfassend eine Steuer- und Stromversorgungseinheit (50) zum individuellen Steuern des Stroms, der an die erste LED (21) bzw. die zweite LED (22) abgegeben wird.

**9.** Weiße LED-Lichtquelle (100) nach Anspruch 8, wobei die Steuer- und Stromversorgungseinheit (50) angeordnet ist, um den Strom zu reduzieren, der an die zweite LED (22) abgegeben wird, und um den Strom, der an die erste LED (21) abgegeben wird, im Wesentlichen konstant zu halten, wenn die zweite LED-Lichtquelle (100) in einen Dimmzustand versetzt wird.

## Revendications

**1.** Source de lumière à diode électroluminescente blanche (LED) (100) comprenant :

- une première LED (21) qui est une LED proche de l'ultraviolet (UV) avec une crête d'émission dans la plage d'environ 370 nm à 400 nm, et
- une seconde LED (22) qui est une LED bleue avec une crête d'émission dans la plage d'environ 400 nm à 480 nm,

dans laquelle la première LED (21) et la seconde LED (22) peuvent être commandées sélectivement toutes les deux,

dans laquelle la source de lumière à LED blanche (100) comprend en outre une couche luminescente (30) disposée sur une surface qui est irradiée par la première LED (21) et la seconde LED (22), et **caractérisée en ce que** la couche luminescente (30) comprend :

- une première composition luminescente qui est un phosphore émettant dans le vert à jauneorange qui est efficacement luminescent suite à l'excitation par un rayonnement dans une plage entre 460 nm et 470 nm, le phosphore émettant dans le vert à jaune-orange étant agencé pour émettre un rayonnement dans une plage entre 520 nm et 580 nm, et
- une seconde composition luminescente étant un phosphore émettant dans le rouge qui est efficacement luminescent suite à l'excitation par un rayonnement dans une plage entre 370 nm et 400 nm, le phosphore émettant dans le rouge étant agencé pour émettre un rayonnement ayant une crête dans une plage entre 600 nm et 680 nm.

2. Source de lumière à LED blanche (100) selon la revendication 1, comprenant en outre une ampoule transparente (40), dans laquelle la première LED (21) et la seconde LED (22) sont montées dans l'ampoule (40), et dans laquelle la couche luminescente (30) est disposée sur la surface de l'ampoule (40).

3. Source de lumière à LED blanche (100) selon la revendication 2, dans lequel l'ampoule (40) est au moins partiellement recouverte par un revêtement réfléchissant.

4. Source de lumière à LED blanche (100) selon la revendication 2, dans laquelle l'ampoule (40) présente la forme d'un système d'éclairage général ou une forme conique de lampes réfléchissantes.

5. Source de lumière à LED blanche (100) selon la revendication 1, dans laquelle les LED (21, 22) sont montées sur un puits de chaleur (11).

6. Source de lumière à LED blanche (100) selon la revendication 1, dans laquelle la seconde composition luminescente comprend un matériau présentant une composition selon les formules générales $(Sr_{1-x-y}Ca_xBa_y)_{2-z}Si_5N_8:Eu_z$ ($0 \leq x \leq 1, 0 \leq y \leq 1$, $0,1 \leq z \leq 2$), $(Sr_{1-x}Ca_x)S:Eu$ ($0 \leq x \leq 1$), $Sr_{1-x-y}Ca_xBa_y)_{3-z}Si_2N_2O_4:Eu_z$ ($0 \leq x \leq 1$, $0 \leq y \leq 1$, $0,1 \leq z \leq 3$), $CaAlSiN_3:Eu$, $MLn_{1-z}(Mo_{1-x}W_x)_2O_8:Eu_z$ (avec M = Li, Na, K, Rb, Cs et Ln = Y, La, Ga et $0 \leq x \leq 1$, $0,1 \leq z \leq 1$), $Ln_{2-z}(Mo_{1-x}W_x)_2O_9:Euz$ (avec Ln = La, Gd, Lu et $0 \leq x \leq 1$, $0,2 \leq z \leq 2$), ou $Ln_{2-z}(Mo_{1-x}W_x)_3O_{12}:Eu_z$ (avec Ln = La, Gd, Lu et $0 \leq x \leq 1$, $0,2 \leq z \leq 2$).

7. Source de lumière à LED blanche (100) selon la revendication 1, dans laquelle la première composition luminescente comprend un matériau présentant une composition selon les formules générales $(Sr_{1-x-y}Ca_xBa_y)_2SiO_4:Eu$ ($0 \leq x \leq 1$, $0 \leq y \leq 1$), $(Sr_{1-x}Ca_x)Si_2N_2O_3:Eu$ ($0 \leq x \leq 1$), $SrLi_2SiO_4:Eu$, $(Y_{1-x-y-z}Lu_xGd_yTb_z)_3(Al_{1-a}Ga_a)_5O_{12}:Ce$ ($0 \leq a \leq 1$, $0 \leq x \leq 1$, $0 \leq y \leq 1$, $0 \leq z \leq 1$), $Y_3Al_{5-x}Si_xO_{12-x}N_xCe$, ou $CaAlSiN_3:Ce$.

8. Source de lumière à LED blanche (100) selon la revendication 1, comprenant en outre une unité de commande et d'alimentation en énergie (50) pour la commande individuelle de la puissance fournie à la première LED (21) et la seconde LED (22) respectivement.

9. Source de lumière à LED blanche (100) selon la revendication 8, dans laquelle l'unité de commande et d'alimentation en énergie (50) est agencée pour réduire la puissance fournie à la seconde LED (22), et pour maintenir la puissance fournie à la première LED (21) sensiblement constante lorsque la source de lumière à LED blanche (100) est réglée à un état de gradation.

FIG. 1

FIG. 2

FIG. 3

FIG. 4

FIG. 5

FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0063977 A1
- JP 2003051209 A
- DE 102005020695 A1
- WO 0057490 A
- US 2007258240 A1